(19) Europäisches Patentamt
European Patent Office
Office européen des brevets

(11) EP 1 850 170 A1

(12) EUROPEAN PATENT APPLICATION

(43) Date of publication:
31.10.2007 Bulletin 2007/44

(51) Int Cl.:
$G02F\ 1/225^{(2006.01)}$ $G01J\ 9/02^{(2006.01)}$
$H01S\ 5/0687^{(2006.01)}$

(21) Application number: 06300846.0

(22) Date of filing: 01.08.2006

(84) Designated Contracting States:
AT BE BG CH CY CZ DE DK EE ES FI FR GB GR
HU IE IS IT LI LT LU LV MC NL PL PT RO SE SI
SK TR
Designated Extension States:
AL BA HR MK YU

(71) Applicant: Alcatel Lucent
75008 Paris (FR)

(72) Inventor: Pfeiffer, Thomas, Dr.
70569 Stuttgart (DE)

(74) Representative: Rausch, Gabriele
Alcatel-Lucent Deutschland AG
Intellectual Property Group
Lorenzstrasse 10
70435 Stuttgart (DE)

Remarks:
Amended claims in accordance with Rule 86 (2) EPC.

(54) **Finetuning of embedded wavelength monitor**

(57) The present invention relates to a method for fine-tuning an optical device (10, 110, 210) comprising two Mach Zehnder devices being detuned with respect to each other. The invention also relates to an optical device (10, 110, 210) comprising two Mach Zehnder devices. A first optical delay ($\Delta L_{opt}$) is introduced into a path (12, 112, 212) common to both Mach Zehnder devices in order to introduce a path length difference which is common to both Mach Zehnder devices and which amounts to said first optical delay ($\Delta L_{opt}$). A second optical delay ($\delta l$) is introduced into at least one path which belongs to only one of the Mach Zehnder devices, in order to detune the two Mach Zehnder devices with respect to each other.

Fig. 7

Description

BACKGROUND OF THE INVENTION

The present invention relates to a method for fine-tuning an optical device comprising two Mach Zehnder devices detuned with respect to one another. The invention further relates to an optical device comprising two Mach Zehnder devices detuned with respect to one another. Furthermore the invention relates to a wavelength monitor comprising said optical device and an optical receiver comprising said optical device.

A Mach Zehnder device is an optical interferometer with a periodic output function characterized by the path length difference in between the two paths of the interferometer. Two Mach Zehnder devices are detuned with respect to one another if the path length difference of one Mach Zehnder device differs from the path length difference of the other Mach Zehnder device.

Wavelength monitors are used to measure wavelength drifts of e.g. transmitter lasers of transceiver modules in optical telecommunication systems. Transmitter lasers used as optical sources in such systems are subject to ageing and temperature induced wavelength drifts. Such optical networks use for example a wavelength allocation scheme with 20 nm wide wavebands, centered about defined center wavelengths (Coarse Wavelength Division Multiplex, CWDM).

A wavelength monitor provides a basis for readjusting the optical source such that the optical signal remains within the allocated waveband. A Mach Zehnder device can be used to monitor the wavelength output by such a transmitter laser and also provide a measure for the amount of readjustment needed. The wavelength response of the Mach Zehnder device may however not match exactly with the wavelength band windows that it was made for. This can be due to manufacturing tolerances and due to temperature drifts. State of the art for adjusting the response of a Mach Zehnder device is adjusting the path length difference of the two paths of the interferometer by adjusting the optical delay inside the interferometer by applying heat or mechanical stress or by mechanically moving mirrors or similar means. Heating requires additional electrical power and control loops. Mechanically moving parts are expensive and troublesome to implement with a high reliability and they require significant mechanical parts inside the optical transceiver module.

In EP 0 883 259 A2 a receiver for receiving optical coded signals has been proposed. The proposed receiver comprises two optical periodic filters, e. g. Mach Zehnder devices. The two optical periodic filters are detuned with respect to one another. In the electronic domain, the outputs of the two optical periodic filters are used to stabilize the filter function.

OBJECT OF THE INVENTION

It is an object of the invention to provide a method for fine-tuning an optical device comprising two Mach Zehnder devices which are slightly detuned with respect to each other, so that the overall response in the electronic domain of the optical device can be fine-tuned.

It is also an object of the invention to provide a stabilized optical device comprising two Mach Zehnder devices which are slightly detuned with respect to each other.

It is also an object of the invention to provide a stabilized wavelength monitor as well as a stabilized receiver.

SUMMARY OF THE INVENTION

These objects, and others that appear below, are achieved by a method according to claim 1, an optical device according to claim 7, a corresponding wavelength monitor according to claim 9 and a corresponding receiver according to claim 10.

According to a first aspect of the invention, two different Mach Zehnder devices which are slightly detuned relative to one another are used to fine-tune and stabilize an optical device.

According to another aspect of the invention, one first optical delay which defines the frequency periodicity and the place of minima and maxima of the arrangement and which is large compared to a second optical delay is introduced common to both Mach Zehnder devices. The fine tune in form of the second optical delay is introduced in a separate stage. This is advantageous compared to introducing two separate large optical delays which must differ from each other by exactly the second optical delay.

According to another aspect of the invention, the outputs, e. g. wavelength responses, of the two different Mach Zehnder devices are electronically combined. The weighting factors for the individual responses can be set in the electronic domain thereby adjusting the effective combined response of the device. It is advantageous that this concept can be implemented based on electronic signal processing, which can be done cheaply and efficiently without the need for high additional electrical power or mechanically moving parts.

BRIEF DESCRIPTION OF THE DRAWINGS

Other characteristics and advantages of the invention will become apparent in the following detailed description of preferred embodiments of the invention illustrated by the accompanying drawings given by way of nonlimiting illustrations. The same reference numerals may be used in different figures of the drawings to identify the same or similar elements.

Fig. 1      shows a schematic overview of a preferred embodiment of an inventive optical device being realized by using prisms,

Fig. 2 shows the working principle of an embodiment of the invention employing cross-fading of the outputs of both Mach Zehnder devices,

Fig. 3 shows an example of the weighting factor β,

Fig. 4 shows an example of a wavelength response of an optical device applying the inventive method,

Fig. 5 shows a schematic overview of a transceiver employing an embodiment of an inventive optical device

Fig. 6 shows a schematic overview of another embodiment of an inventive optical device being realized by using another micro optic set-up,

Fig. 7 shows a schematic overview of another embodiment of an inventive optical device being realized by using Planar Lightwave Circuit technology, and

Fig. 8 shows a schematic overview of a receiver employing an embodiment of an inventive optical device.

## DETAILED DESCRIPTION OF THE INVENTION

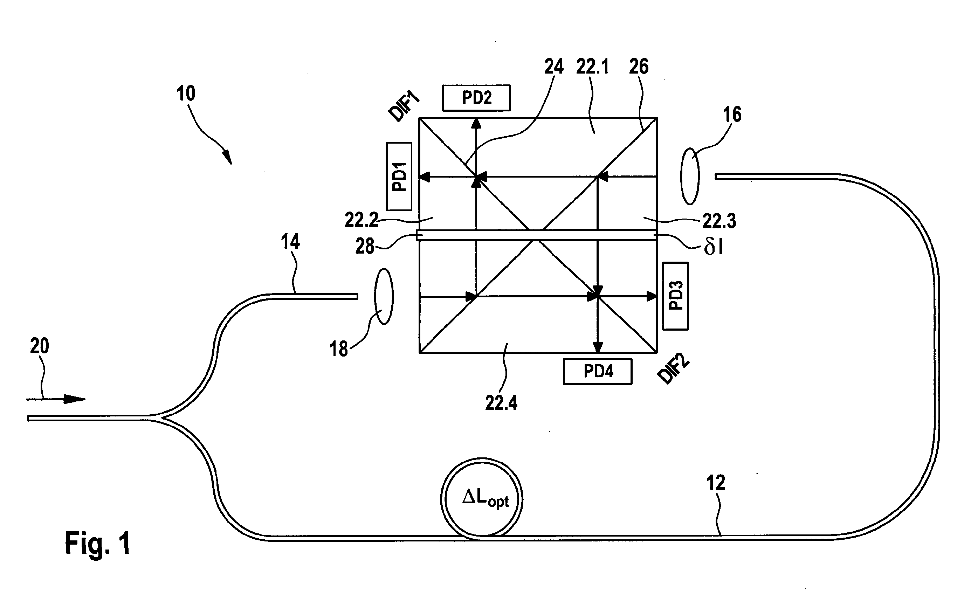

Fig. 1 shows a schematic overview of an embodiment of an inventive optical device 10 being realized by using prisms 22.1, 22.2, 22.3, 22.4, all having the same refractive index. An incoming optical signal is split to both feeder arms 12, 14. The delay on both feeder arms 12, 14 is identical except for the first optical delay $\Delta L_{opt}$ introduced in path 12. The paths 12 and 14 each belong to both Mach Zehnder devices. Paths 12 and 14 belong to different internal paths in each Mach Zehnder device. The signal at the end of path 12 passes through lens 16 before entering the prism block 22. The signal at the end of path 14 passes through lens 18 before entering the prism block 22. The 45° surfaces 24 and 26 are 50/50 splitters, reflecting one half of an incoming optical signal, the other half of the optical signal passing through the surfaces 24 and 26. The photo diodes PD1, PD2, PD3 and PD4 measure the optical signals and convert them into electronic signals, that can be treated in the electronic domain.

In the example shown in Fig. 1, the second optical delay δl' is equal to the third optical delay δl''. In the following example the second optical delay δl' and the optical delay δl'' are both equal to δl. δl is introduced in both Mach Zehnder devices. The Mach Zehnder device with outputs to photo diodes PD1 and PD2 has a differential path length of $\Delta L_{opt}$-δl in between the output to PD1 compared to the output to PD2. The Mach Zehnder device being output to photo diodes PD3 and PD4 has a differential path length of $\Delta L_{opt}$ + δl in between the output to PD3 compared to the output to PD4. This results in the two Mach Zehnder devices being detuned by a delay of 2δl.

Light entering the Mach Zehnder device through path 14 and output to photo diode PD1 experiences a phase shift of a quarter wavelength λ/4 being reflected at surface 26, an optical delay amounting to δl when passing through middle layer 28 and another phase shift of a quarter wavelength λ/4 being reflected at surface 24. Light entering the Mach Zehnder device through path 16 and output to photo diode PD1 experiences an optical delay of $\Delta L_{opt}$ in path 16 and no phase shifts when traveling through surfaces 24 and 26. Thus, the light beams being output to PD1 are shifted by $\Delta L_{opt}$ - δ l -λ/ 2 with respect to one another. Light entering the Mach Zehnder device through path 14 and output to photo diode PD2 experiences a phase shift of a quarter wavelength λ/4 being reflected at surface 26, an optical delay amounting to δl when passing through middle layer 28 and no phase shift passing through surface 24. Light entering the Mach Zehnder device through path 16 and output to photo diode PD2 experiences an optical delay of $\Delta L_{opt}$ in path 16 and no phase shift when traveling through surface 26 and a phase shift of a quarter wavelength λ/ 4 being reflected at surface 24. Thus, the outputs measured at PD1 and PD2 constitute the two outputs of a Mach Zehnder device with a differential path length of $\Delta L_{opt}$-δl.

The Free Spectral Range is defined as $FSR = \dfrac{c}{\Delta L_{opt}}$

and represents the periodicity of the intensity transmission at the outputs of the Mach Zehnder device. The output of PD2 is shifted by $\dfrac{FSR}{2}$ with respect to the output of PD1.

Light entering the Mach Zehnder device through path 14 and output to photo diode PD3 experiences no phase shift when passing through surfaces 26 and 24. Light entering the Mach Zehnder device through path 16 and output to photo diode PD3 experiences an optical delay of $\Delta L_{opt}$ in path 16, a phase shift of a quarter wavelength λ/4 being reflected at surface 26, an optical delay amounting to δl when passing through middle layer 28 and another phase shift of a quarter wavelength λ/4 being reflected at surface 26. Thus, the light beams being output to PD3 are shifted by $\Delta L_{opt}$ + δl + λ/2 with respect to one another. Light entering the Mach Zehnder device through path 14 and output to photo diode PD4 experiences no phase shift when passing through surface 26 and a phase shift of a quarter wavelength λ/4 being reflected at surface 24. Light entering the Mach Zehnder device through path 16 and output to photo diode PD4 experiences an optical delay of $\Delta L_{opt}$ in path 16, a phase shift of a quarter wavelength λ/4 being reflected at surface 26, an optical delay amounting to δl when passing through middle layer 28 and no phase shift when passing through surface 24. Thus, the light beams being output to PD4 are shifted by $\Delta L_{opt}$ + δl with respect to one another. Thus, the outputs measured at PD3 and PD4 constitute the two outputs of a Mach Zehnder device with a differential path length of $\Delta L_{opt}$, + δl. The output of PD4

is shifted by $\dfrac{FSR}{2}$ with respect to the output of PD3.

The overall set-up constitutes two Mach-Zehnder devices being detuned with respect to each other by 2δl. In Fig. 1, δl is the same in both Mach Zehnder devices. It is of course possible to introduce optical delays δl', δl" of different size in each of the Mach Zehnder devices, resulting in the two Mach-Zehnder devices being detuned with respect to each other by δl'+ δl".

In the electronic domain a difference DIF1 of the signals measured at PD1 and PD2 and a difference DIF2 of the signals measured at PD3 and PD4 can be calculated or obtained using a subtractor realized by an electronic circuit.

For example, δl in Fig. 1 can advantageously be chosen to be a layer with an optical thickness of $\lambda_0/8$, $\lambda_0$ being the vacuum wavelength at which the device is designed to work. This would in this example result in the two Mach Zehnder devices being detuned by $\lambda_0/4$. Alternatively, δl' + δl" can be chosen differently, but summing up to δl' + δl" = $\lambda_0/4$.

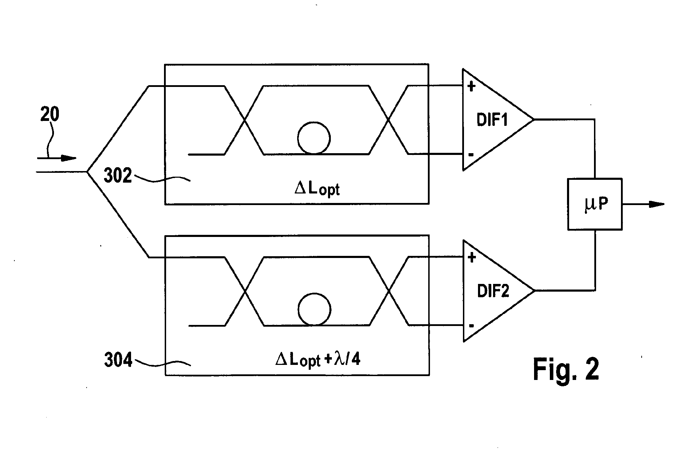

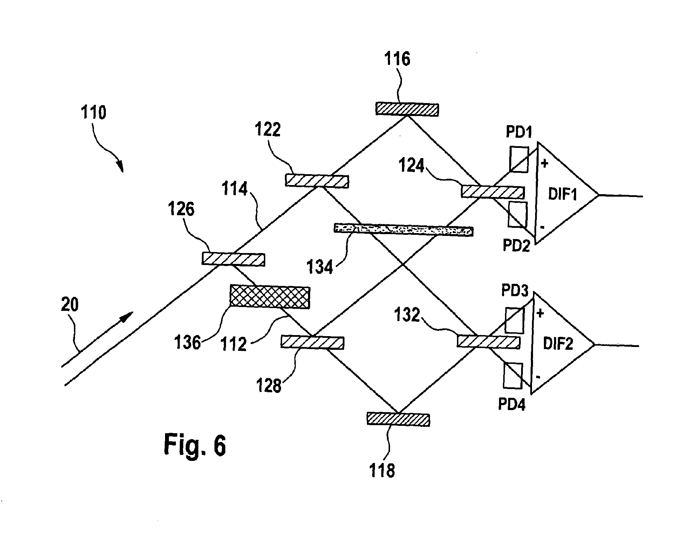

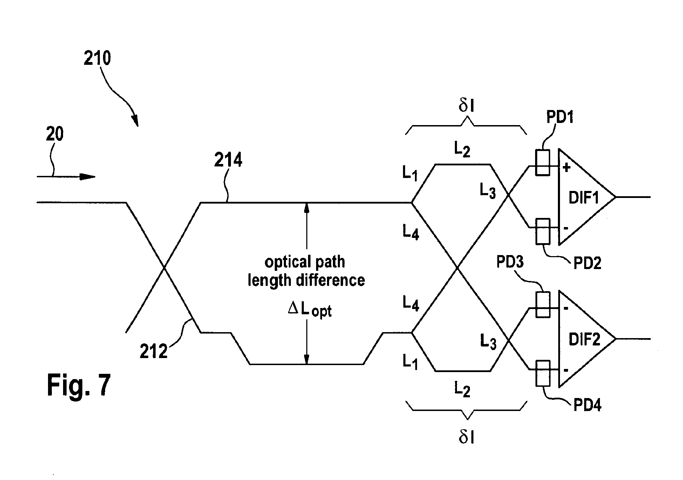

The working principle of such two Mach Zehnder devices being detuned by $\lambda_0/4$ and having a common differential path delay of $\Delta L_{opt}$ is shown in Fig. 2. It will become apparent why choosing a detuning amount of $\lambda_0/4$ is advantageous. The detuning amount can be advantageously achieved by an embodiment of an inventive device shown in Fig. 1 and described above with respect to Fig. 1. Other examples of possible embodiments of inventive devices will be given in Fig. 6 in Fig. 7, respectively, and will be described referring Fig. 6 and Fig. 7. The input light signal is split into two signals. One enters a first Mach Zehnder device 302 with a differential path delay of $\Delta L_{opt}$. The other one enters a second Mach Zehnder device 304 with $\Delta L_{opt}$ + $\lambda_0/4$. At DIF1 the difference of the two output signals at the two outputs of the Mach Zehnder device 302 is calculated. At DIF2 the difference of the two output signals at the two outputs of the Mach Zehnder device 304 is calculated. DIF1 gives an output signal of $T_I(\lambda) = \cos(2\pi \dfrac{\Delta L_{opt}}{\lambda})$. DIF2

gives an output signal of $T_Q(\lambda) \approx \sin(2\pi \dfrac{\Delta L_{opt}}{\lambda})$,

the indexes I and Q standing for In-Phase and Quadrature component, respectively. The microprocessor μP

calculates the effective response of the device using weighting factors. An example for an effective response using one weighting factor β is

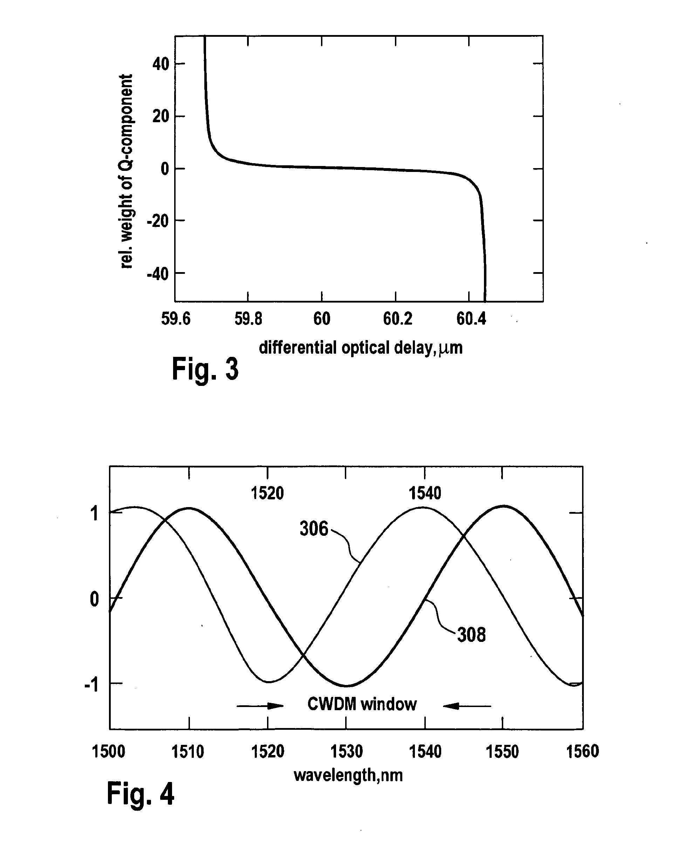

$$T_{IQ}(\lambda) = \frac{T_I(\lambda) + \beta T_Q(\lambda)}{\sqrt{1 + \beta^2}}.$$ β can for example be defined during calibration, taken from a characteristic curve or look-up table. β values can be found experimentally by feeding the device with sources 20 with known optical spectra. Temperature dependencies of the correction factor β can be taken into account by measuring different appropriate values of β at different temperatures and storing them in a look-up table. could also be measured and stored in a look-up table. β could also be chosen

to be $\beta = 2\pi \dfrac{\Delta L_{opt}}{\lambda_0}$. In Fig. 3 an example of the correction factor β is shown. The shown correction factor has the form of the function $\beta = -\tan(2\pi \dfrac{\Delta L_{opt}}{\lambda_0})$. In

the effective response of the device the in-phase part has the weight 1 and the quadrature output has the weight β.

Fig. 4 shows an example of a wavelength response of an optical device applying the inventive method. The response of a Mach Zehnder device is periodic with frequency. In the regions of wavelength and frequency treated by this invention, this corresponds with sufficient accuracy to wavelength periodicity. The output 308 with a maximum at 1549 nm is shifted out of the wanted wavelength band. The output 306 with a maximum at 1540 nm is the output achieved applying an inventive optical device with two Mach Zehnder devices being detuned by λ/4 with respect to each other and appropriate treatment in the electronic domain. The output 306 with a maximum at 1540 nm is matched exactly to the desired CWDM window. The output signal is furthermore approximately linear in the region of the zero-crossing (approx. 1530 nm) and can therefore be used for tuning the laser. CWDM signals comprise several wavelength windows next to each other. The output signal 306 can be used for several CWDM signals next to each other. Alternatively or additionally a different signal with a different weighting factor β can be used for some or all of the other wavelength windows.

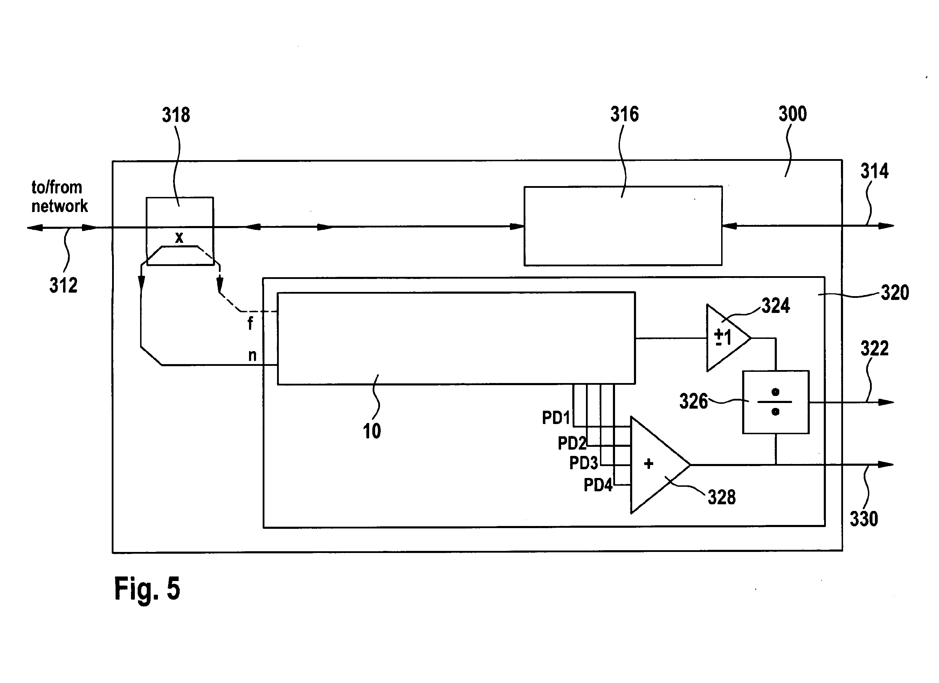

A wavelength response given by the example in Fig. 4 can be used in a wavelength monitor as shown in Fig. 5. Shown is a transceiver module 300 of an optical network. The transceiver module 300 is connected to the optical network by input /output line 312 and input/output line 314. The sub module 316 performs the tasks of data transmission and reception.

An optical coupler 318 drops a signal either from the far end to a far-end input f of the wavelength monitor 320 - dotted line - or from the near end to a near-end input n of the wavelength monitor 320 - solid line . The wavelength monitor comprises for example an inventive optical device 10.

Alternatively optical devices 110, 210 as described with respect to Fig. 6 and Fig. 7 can be used. The switch 324 gives the possibility to invert the signal output by the microprocessor μP. With this one can achieve that the output characteristic of the effective signal over the wavelength has the same slope in each wavelength window. Without this one would have falling slopes in every other band and raising slopes in between. Of course such inversion or not inversion can be made fixed instead of switchable, when treating only one wavelength window. It is also possible to do the inversion at some other point of the signal treatment.

The adder 328 adds the amplitudes of the outputs PD1, PD2, PD3 and PD4 of the two Mach Zehnder devices, thus building a value indicating the total power of the measured signal. If necessary, such value can be output for other purposes.

The divider 326 divides the output value of the switch 324 by the output value of the adder 328 and thus normalizes the result. This value is given to the output line 322 of the wavelength monitor.

When one wants to tune the laser in the transmitter part of the optical transceiver 300, one has to measure via the near-end input n. Of course it is to be ensured, that during such measuring there will be no input signal at the far-end input f. Then from the signal output to output 322 of the wavelength monitor 320 a signal can be generated to be given to the tuning input line of the transceiver 300 to directly tune its laser.

When one wants to tune the laser in the far end, one has to measure via the far-end input f. Of course it is to be ensured, that during such measuring there will be no input signal at the near-end input n. Then from the signal output to output 322 of the wavelength monitor 320 a signal can be generated to be given to the measured far-end transceiver to tune its laser. Such signal may be a protocol sequence to be sent to the far-end via the normal data channel led through the signal input/output lines 312 and/or 314.

Fig. 6 shows a schematic overview of another embodiment of an inventive optical device being realized by using another micro optic set-up. The parts 122, 124, 126, 128, 132 are half-reflecting 50%/50% mirrors, reflecting half of the light and letting pass the other half. The parts 116 and 118 are 100 % mirrors, reflecting all of the light. Part 136 introduces the optical delay $\Delta L_{opt}$. In the example the second optical delay δl' is equal to the third optical delay δl". In the following example the second optical delay δl' and the optical delay δl" are both equal to δl. The part 134 introduces the optical delay δl, which can advantageously be chosen to amount to $\lambda_0/8$, $\lambda_0$ being the vacuum wavelength for which the device is designed. Of course, the part 134 could be designed in a way, so that a different δl' and δl" are introduced into each Mach Zehnder device. The paths 112 and 114, the paths in between parts 122 and 116, in between parts 116 and 124, in between parts 126 and 128, in between parts 128 and 118 and in between parts 118 and 132 are of the same length $L_0$. The paths in between parts 122 and 132 and in between parts 124 and 128 are of length $2L_0$.

In this setup, the path length difference in between the beams being output to PD1 is $\Delta L_{opt} + \delta l$. The path length difference in between the beams being output to PD2 is also $\Delta L_{opt} + \delta l$. The intensity transmission of the overall output at PD1 is shifted by FSR/2 with respect to the overall output at PD2.

Thus, the output measured at PD1 and PD2 constitutes the two outputs of a Mach Zehnder device with a differential path length of $\Delta L_{opt} + \delta l$.

The path length difference in between the beams being output to PD3 is $\Delta L_{opt}-\delta l$. The path length difference in between the beams being output to PD2 is also $\Delta L_{opt}-\delta l$. The intensity transmission of the overall output at PD3 is shifted by FSR/2 with respect to the overall output at PD4. Thus, the output measured at PD3 and PD4 constitutes the two outputs of a Mach Zehnder device with a differential path length of $\Delta L_{opt}-\delta l$. This results in the two Mach Zehnder devices being detuned by a delay of 2δl. If the delay δl is designed to amount to $\lambda_0/8$, the two Mach Zehnder devices will be detuned with respect to each other by $\lambda_0/4$.

Fig. 7 shows a schematic overview of another embodiment of an inventive optical device being realized by using planar lightwave circuit technology. In this embodiment, waveguides are used to realize the inventive optical device. The optical device 210 comprises two Mach Zehnder devices, one with outputs PD1 and PD2, the other one with outputs PD3 and PD4. $L_1, L_2, L_3, L_4$ have to be chosen, so that $L_4 - (L_1 + L_2 + L_3) = \delta l$ holds. Of course $L_1, L_2, L_3, L_4$ could be chosen differently in each Mach Zehnder device so that in one Mach Zehnder device δl' is introduced and in the other Mach Zehnder device δl" is introduced. In a highly preferred embodiment, δl is the same for both Mach Zehnder devices and is chosen to be $\lambda_0/8$. The optical path length difference $\Delta L_{opt}$ is introduced in path 212, a path common to both Mach Zehnder devices. The other input path 214 has the identical length as path 12, but doesn't introduce the optical path length difference $\Delta L_{opt}$. The optical path length difference of the upper Mach Zehnder device having outputs PD1 and PD2 then amounts to $\Delta L_{opt} + \delta l$. The optical path length difference of the lower Mach Zehnder device having outputs PD3 and PD4 then amounts to $\Delta L_{opt} - \delta l$. This results in a detuning amount of both Mach Zehnder interferometers of 2δl. For the case of $\delta l=\lambda_0/8$, the detuning amounts to $\lambda_0/4$.

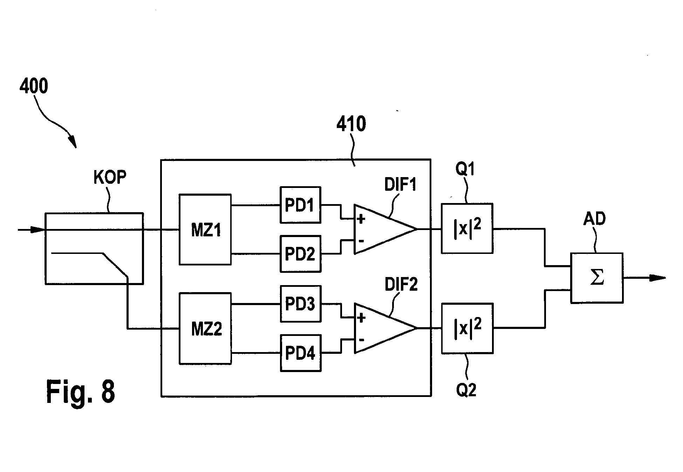

Fig. 8 shows a schematic overview of a receiver 400 employing an embodiment 410 of an inventive optical device. In receivers for optical telecommunication systems employing CDMA (code division multiple access) for certain coding methods periodic filters which have to be matched exactly with the transmitter filters are used.

As filters, Mach Zehnder devices MZ1 and MZ2 can be applied. Wavelength drifts due to e. g. ageing or temperature changes in Mach Zehnder devices have to be compensated in the receiver. The configuration given in Fig. 8 has been proposed in EP 0 883 259 A2 to realize a stabilized receiver. For this purpose the two Mach Zehnder devices MZ1 and MZ2 of 410 have to be detuned with respect to each other by $\lambda_0/4$. The inventive optical device, for example realized according to the embodiment given in Fig. 1 or according to the embodiment given in Fig. 6 or according to the embodiment given in Fig. 7, offers a reliable and exact realization of such detuned Mach Zehnder devices.

The device denoted with the reference numeral 410 in Fig. 8 might be realized using an inventive device, for example the embodiments 10, 110 or 210. The input signal is input to device 410 over a splitter KOP. At the outputs of DIF1 and DIF2, a positive signal of the outputs of DIF1 and DIF2 is generated. This could be the absolute values of DIF1 and DIF2. In the example given in Fig. 8 squaring units Q1 and Q2 square the amplitudes of the outputs of DIF1 and DIF2 respectively. In a further step, the outputs of DIF1 and DIF2 have to be combined. In the example of Fig. 8 an adder AD adds the squared output signals of the squaring units Q1 and Q2. As a result the envelope of the tuning curves of the reception filter is obtained resulting in a less sensitive decoding of the received signal.

## Claims

1. Method for fine-tuning an optical device (10, 110, 210) comprising two Mach Zehnder devices being detuned with respect to each other, by introducing a first optical delay ($\Delta L_{opt}$) into a path (12, 112, 212) common to both Mach Zehnder devices in order to introduce a path length difference which is common to both Mach Zehnder devices and which amounts to said first optical delay ($\Delta L_{opt}$) and introducing a second optical delay ($\delta l$, $\delta l'$) into at least one path which belongs to only one of the Mach Zehnder devices, in order to detune the two Mach Zehnder devices with respect to each other.

2. Method according to claim 1, wherein said second optical delay ($\delta l$) amounts to a quarter of the wavelength ($\lambda_0$) at which the optical device (10, 110, 210) is designed to work, in order to detune said two Mach Zehnder devices by an amount of a quarter of the wavelength ($\lambda_0$) at which the optical device (10, 110, 210) is designed to work.

3. Method according to claim 1, wherein said second optical delay ($\delta l$, $\delta l'$) is introduced into a path belonging to the first one of said two Mach Zehnder devices, and a third optical delay ($\delta l$, $\delta l''$) is introduced into a path belonging to a second one of the Mach Zehnder devices, in order to detune said two Mach Zehnder devices by an amount of the sum of said second delay ($\delta l$, $\delta l'$) and said third delay ($\delta l$, $\delta l''$).

4. Method according to claim 3, wherein the sum of said second optical delay ($\delta l'$) and said third optical delay ($\delta l''$) amounts to a quarter of the wavelength ($\lambda_0$) at which the optical device (10, 110, 210) is designed to work.

5. Method according to claim 1, further comprising the step of cross-fading the output of one of the Mach Zehnder devices with the output of the other one of the Mach Zehnder devices in the electronic domain.

6. Method according to claim 1, further comprising the step of combining a positive signal obtained from the amplitude of the output of one of the Mach Zehnder devices with a positive signal obtained from the amplitude of the output of the other one of the Mach Zehnder devices in the electronic domain.

7. Optical device (10, 110, 210) comprising two Mach Zehnder devices, comprising a path (12, 1 12, 212) common to both Mach Zehnder devices, said path (12, 1 12, 212) introducing a path length difference which is common to both Mach Zehnder devices and which amounts to a first optical delay ($\Delta L_{opt}$), said two Mach Zehnder devices being detuned with respect to each other by a second optical delay ($\delta l$, $\delta l'$), which is introduced in a path which belongs to only one of the Mach Zehnder devices.

8. Optical (10, 110, 210) device according to claim 7, **characterized by** said two Mach Zehnder devices being detuned by an amount the sum of said second optical delay ($\delta l'$) and a third optical delay ($\delta l''$) said second optical delay ($\delta l$, $\delta l'$) being introduced into a path belonging to the first one of said two Mach Zehnder devices, and said third optical delay ($\delta l$, $\delta l''$) being introduced into a path belonging to a second one of the Mach Zehnder devices.

9. Wavelength monitor (320) comprising an optical device (10, 110, 210) according to claim 7.

10. Receiver (400) for optically encoded signals comprising an optical device (10, 110, 210) according to claim 7.

**Amended claims in accordance with Rule 86(2) EPC.**

1. Method for fine-tuning an optical device (10, 110, 210) comprising two Mach Zehnder devices being detuned with respect to each other, by introducing a

first optical delay ($\Delta L_{opt}$) into a path (12, 112, 212) common to both Mach Zehnder devices in order to introduce a path length difference which is common to both Mach Zehnder devices and which amounts to said first optical delay ($\Delta L_{opt}$) and introducing a second optical delay ($\delta l$) into at least one path which belongs to only one of the Mach Zehnder devices, in order to detune the two Mach Zehnder devices with respect to each other.

**2.** Method according to claim 1, wherein said second optical delay ($\delta l$) amounts to a quarter of the wavelength ($\lambda_0$) at which the optical device (10, 110, 210) is designed to work, in order to detune said two Mach Zehnder devices by an amount of a quarter of the wavelength ($\lambda_0$) at which the optical device (10, 110, 210) is designed to work.

**3.** Method according to claim1, wherein said second optical delay ($\delta l$) is introduced into a path belonging to the first one of said two Mach Zehnder devices, and a third optical delay ($\delta l$) is introduced into a path belonging to a second one of the Mach Zehnder devices, in order to detune said two Mach Zehnder devices by an amount of the sum of said second delay ($\delta l$) and said third delay ($\delta l$).

**4.** Method according to claim 3, wherein the sum of said second optical delay and said third optical delay amounts to a quarter of the wavelength ($\lambda_0$) at which the optical device (10, 110, 210) is designed to work.

**5.** Method according to claim 1, further comprising the step of cross-fading the output of one of the Mach Zehnder devices with the output of the other one of the Mach Zehnder devices in the electronic domain.

**6.** Method according to claim 1, further comprising the step of combining a positive signal obtained from the amplitude of the output of one of the Mach Zehnder devices with a positive signal obtained from the amplitude of the output of the other one of the Mach Zehnder devices in the electronic domain.

**7.** Optical device (10, 110, 210) comprising two Mach Zehnder devices, comprising a path (12, 112, 212) common to both Mach Zehnder devices, said path (12, 112, 212) introducing a path length difference which is common to both Mach Zehnder devices and which amounts to a first optical delay ($\Delta L_{opt}$), said two Mach Zehnder devices being detuned with respect to each other by a second optical delay ($\delta l$), which is introduced in a path which belongs to only one of the Mach Zehnder devices.

**8.** Optical (10, 110, 210) device according to claim 7, **characterized by** said two Mach Zehnder devices being detuned by an amount the sum of said second optical delay and a third optical delay said second optical delay ($\delta l$) being introduced into a path belonging to the first one of said two Mach Zehnder devices, and said third optical delay ($\delta l$) being introduced into a path belonging to a second one of the Mach Zehnder devices.

**9.** Wavelength monitor (320) comprising an optical device (10, 110, 210) according to claim 7.

**10.** Receiver (400) for optically encoded signals comprising an optical device (10, 110, 210) according to claim 7.

Fig. 1

EP 1 850 170 A1

**Fig. 2**

**Fig. 3**

**Fig. 4**

Fig. 5

Fig. 6

**Fig. 7**

**Fig. 8**

**European Patent Office**

## EUROPEAN SEARCH REPORT

Application Number

EP 06 30 0846

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/022283 A1 (KUZNETSOV MARK E [US] ET AL) 5 February 2004 (2004-02-05) * paragraphs [0051] - [0053], [0064] - [0073], [0079]; figures 6,9,12 * | 1-10 | INV. G02F1/225 G01J9/02 ADD. H01S5/0687 |
| X | GB 2 308 222 A (NORTHERN TELECOM LTD [CA]) 18 June 1997 (1997-06-18) * page 2, line 19 - page 3, line 34; figure 1 * | 1,3,7,8 | |
| X | US 6 650 458 B1 (PROSYK KELVIN [CA] ET AL) 18 November 2003 (2003-11-18) * column 7, line 37 - column 10, line 28; figure 1 * | 1,3,7,8 | |
| D,X | DE 197 22 370 A1 (ALSTHOM CGE ALCATEL [FR]) 3 December 1998 (1998-12-03) * column 2, line 17 - column 4, line 53; figures 4,5 * | 1,2,7,10 | |
| X | US 2003/076502 A1 (VERMA KAUSHAL KUMAR [US] ET AL) 24 April 2003 (2003-04-24) * paragraphs [0051] - [0067]; figures 8-11 * | 1,2,7,9 | TECHNICAL FIELDS SEARCHED (IPC) G02F G01J H04B G02B H01S |

The present search report has been drawn up for all claims

| Place of search | Date of completion of the search | Examiner |
|---|---|---|
| Munich | 2 January 2007 | Laenen, Robert |

EPO FORM 1503 03.82 (P04C01)

## ANNEX TO THE EUROPEAN SEARCH REPORT
## ON EUROPEAN PATENT APPLICATION NO.

EP 06 30 0846

This annex lists the patent family members relating to the patent documents cited in the above-mentioned European search report.
The members are as contained in the European Patent Office EDP file on
The European Patent Office is in no way liable for these particulars which are merely given for the purpose of information.

02-01-2007

| Patent document cited in search report | | | Publication date | Patent family member(s) | | | Publication date |
|---|---|---|---|---|---|---|---|
| US 2004022283 | A1 | | 05-02-2004 | NONE | | | |
| GB 2308222 | A | | 18-06-1997 | DE | 69603935 | D1 | 30-09-1999 |
| | | | | DE | 69603935 | T2 | 09-12-1999 |
| | | | | EP | 0779689 | A2 | 18-06-1997 |
| | | | | US | 5872649 | A | 16-02-1999 |
| US 6650458 | B1 | | 18-11-2003 | AU | 2003299061 | A1 | 19-04-2004 |
| | | | | EP | 1550246 | A1 | 06-07-2005 |
| | | | | WO | 2004030242 | A1 | 08-04-2004 |
| DE 19722370 | A1 | | 03-12-1998 | CA | 2235834 | A1 | 28-11-1998 |
| | | | | EP | 0883259 | A2 | 09-12-1998 |
| | | | | JP | 11008594 | A | 12-01-1999 |
| | | | | US | 6404528 | B1 | 11-06-2002 |
| US 2003076502 | A1 | | 24-04-2003 | NONE | | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• EP 0883259 A2